# EUROPEAN PATENT APPLICATION

(11) **EP 4 611 491 A1**
(43) Date of publication of application: **03.09.2025**
(21) Application number: 25154846.7
(22) Date of filing: 30.01.2025
(51) Int. Cl.: H05K 1/18, H05K 3/28

(54) **COMPONENT CARRIER AND METHOD FOR MANUFACTURING THE COMPONENT CARRIER**

(30) Priority: 21.02.2024 CN 202410197027
(71) Applicant: AT & S Austria Technologie & Systemtechnik Aktiengesellschaft, 8700 Leoben-Hinterberg (AT)
(72) Inventor: ZHOU, Max, Chongqing, 400063 (CN); NG, Shawn, 12300 Butterworth, Penang (MY); XIANG, Zhongmiao (Tony), MianYang City, 622760 (CN)
(74) Representative: Donatello, Daniele

(57) **Abstract**

The present application provides a component carrier and method for manufacturing the component carrier. The component carrier (100) comprises a stack (102) comprising at least one electrically conductive layer structure (104) and at least one electrically insulating layer structure (106), a through hole (108) extending vertically through the stack (102) and being delimited by sidewalls (110) of the stack (102) having a lateral constriction (130) in between opposing main surfaces (114, 116) of the stack (102), and an electrically insulating coating (112) covering part of said opposing main surfaces (114, 116) and at least part of said sidewalls (110) of the stack (102).

## Description

### Field of the Invention

The invention relates to a component carrier and a method of manufacturing a component carrier.

### Technological Background

In the context of growing product functionalities of component carriers equipped with one or more components and increasing miniaturization of such components as well as a rising number of components to be connected to the component carriers such as printed circuit boards, increasingly more powerful array-like components or packages having several components are being employed, which have a plurality of contacts or connections, with ever smaller spacing between these contacts. In particular, component carriers shall be mechanically robust and electrically reliable so as to be operable even under harsh conditions.

### Summary of the Invention

There may be a need to provide a hole in a component carrier in a failure robust way and with high precision.

According to an exemplary embodiment of the invention, a component carrier is provided which comprises a stack comprising at least one electrically conductive layer structure and at least one electrically insulating layer structure, a through hole extending vertically through the stack and being delimited by sidewalls of the stack having a lateral constriction in between opposing main surfaces of the stack, and an electrically insulating coating covering part of said opposing main surfaces and at least part of said sidewalls of the stack (for example covering the entire sidewalls of the stack).

According to another exemplary embodiment of the invention, a method of manufacturing a component carrier is provided, wherein the method comprises providing a stack comprising at least one electrically conductive layer structure and at least one electrically insulating layer structure, forming a through hole extending vertically through the stack and being delimited by sidewalls of the stack having a lateral constriction between opposing main surfaces of the stack, and forming an electrically insulating coating covering part of said opposing main surfaces and at least part of said sidewalls of the stack.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. In particular, a component carrier may also be embodied as a flexible or semirigid substrate. A component carrier may also be a hybrid board combining different ones of the above mentioned types of component carriers.

In the context of the present application, the term "stack" may particularly denote an arrangement of multiple planar layer structures which are mounted in parallel on top of one another. For example, the stack may be a laminated stack, i.e. comprising a plurality of layer structures connected by the application of heat and/or pressure.

In the context of the present application, the term "layer structure" may particularly denote a continuous layer, a patterned layer or a plurality of nonconsecutive islands within a common plane.

In the context of the present application, the term "through hole" may particularly denote an opening in the component carrier structure which extends through the entire stack.

In the context of the present application, the term "vertical through hole" may particularly denote that the through hole extends through the stack so that a central axis or a symmetry axis of the through hole is perpendicular or substantially perpendicular to parallel main surfaces of the stack.

In the context of the present application, the term "vertical through hole delimiting sidewalls of the stack having a lateral constriction" may particularly denote the fact that the sidewalls of the stack which define the lateral limits of the through hole are not completely oriented along a vertical direction perpendicular to main surfaces of the stack but, in a cross-sectional view, have a bottleneck. It is also possible that the sidewall comprises more than one constriction or bottleneck. On any side with respect to the at least one lateral constriction, the sidewalls may be straight (for instance vertical or inclined) or curved (for instance in a concave and/or convex fashion). Cross-sectional areas of the through hole may be different at different height levels of the stack. Preferably, a through hole delimited by sidewalls of a stack having a lateral constriction may be formed by laser drilling, i.e. by processing the stack with a drilling laser beam from both sides of the stack. For instance, a first laser cutting or drilling process may be executed from one main surface of the stack, and a second laser cutting or drilling process may be executed (for example subsequently or simultaneously) from the opposing other main surface of the stack to thereby form a through hole with lateral constriction. The obtained through hole may for instance have an hourglass shape or a shape defined by two opposingly tapering and connected frustoconical partial holes. By laser processing a layer stack with a laser beam, a through hole with lateral constriction may be formed when the laser parameters (such as laser light wavelength, laser power, irradiation time, etc.) are adjusted correspondingly. A vertical through hole delimiting sidewalls of the stack having a lateral constriction may have a first tapering portion extending into the stack from one of its main surfaces and may have a second tapering portion extending into the stack from the opposing other one of its main surfaces so that the two tapering portions meet each other in an interior of the through hole at a narrow or even narrowest neck forming said lateral constriction. The lateral constriction may form a circumferentially closed lateral constriction, for instance a lateral constriction line or area. A circumferentially closed lateral constriction may define a collar extending laterally into the through hole.

In the context of the present application, the term "electrically insulating coating" may particularly denote an electrically non-conductive filling medium filling only part of the respective through hole while maintaining a void portion of the through hole. The electrically insulating coating may cover or line interior hole-defining sidewalls of the stack laterally or entirely. Such a filling medium may be dielectric (for instance electrically insulating ink).

In the context of the present application, the term "main surface" of a body (such as the stack) may particularly denote one of two largest opposing surfaces of the body. The main surfaces may be connected by circumferential side walls. The thickness of a body, such as a stack, may be defined by the vertical distance between the two opposing main surfaces.

According to an exemplary embodiment, a component carrier (such as a printed circuit board or an integrated circuit substrate) comprises a (preferably laminated) layer stack having one or more through holes. The latter may be formed so as to extend through the stack substantially perpendicular to main surfaces of the stack. Moreover, formation of the through hole(s) may be executed (for instance by laser drilling with appropriate laser operation parameters) in such a way that sidewalls of the stack with lateral constriction are delimited leading to a locally narrow section or bottleneck in an interior of the through hole. Furthermore, an electrically insulating coating may be formed so that the latter coats the opposing main surfaces of the stack only partially and the sidewalls of the stack partially or entirely. Advantageously, a through hole with lateral constriction at sidewalls has turned out as a proper basis for depositing an electrically insulating coating thereon, in particular in terms of homogeneity-related properties of the coating. More specifically, exemplary embodiments of the invention may achieve a highly homogeneous sidewall coverage of a coating in a through hole. A substantially symmetric tapering hourglass-type shape of the through hole may allow for a better control and a more homogeneous thickness and spatial distribution of a coating, such as an ink. Furthermore, a through hole size may be increased by cutting it from both sides of the stack. A highly equal distribution of the (for instance solder mask-type) coating may thus be achieved leading to a high degree of symmetry. Moreover, taking this approach may also keep the lateral shift between the upper through hole portion and the lower through hole portion, meeting at the lateral constriction, small. By adjusting the laser parameters (such as laser power, laser wavelength, irradiation duration) for at least two laser shots (for which the same or different laser parameters may be used) from both opposing main surfaces of the stack, position and diameter of the lateral constriction may be moved to a desired position. This may allow to ensure that the thickness of the coating on the entire sidewall delimiting the through hole is very similar, leading to symmetric properties of the entire component carrier and suppressing undesired phenomena such as warpage and delamination. Moreover, the area increase of the sidewall surface due to its lateral constriction may enhance the adhesion of the coating on the sidewall, which may improve mechanical integrity of the component carrier as a whole. For example, this coating may function as a through hole-related solder resist structure and may protect a covered stack surface from undesired phenomena such as corrosion, oxidation and/or mechanical impact. By locally increasing the functionally active area or volume of the through hole on both sides of the lateral constriction, a respective spatially widened end region of the through hole may be used for accommodating at least part of a component (such as an optical component).

In the following, further exemplary embodiments of the component carrier and the method will be explained.

In an embodiment, a vertical distance from one of the main surfaces to the lateral constriction is in a range from 20% to 80%, in particular in a range from 45% to 55%, of another vertical distance between the opposing main surfaces. Preferably, the lateral constriction may be located at or close to the vertical center of the stack, i.e. at a height level of half of the stack thickness calculated from the bottom main surface thereof, to obtain a high degree of symmetry. In particular in the above mentioned range from 45% to 55%, a low-warpage component carrier with low risk of delamination of layer structures or the coating may be obtained.

In an embodiment, a first part of the through hole tapers from one of said main surfaces of the stack up to the lateral constriction, and a second part of the through hole tapers from the other one of said main surfaces of the stack up to the lateral constriction. The lateral constriction may be the narrowest part of the through hole where the tapering direction changes. Thus, the two tapering parts may taper along inverse tapering directions and may meet at a narrowest interior position corresponding to the lateral constriction. Preferably, each of the first part and the second part may be a corresponding frustoconical part of the through hole.

In an embodiment, the first part and the second part are connected one to each other at the lateral constriction or are connected through an intermediate portion. Thus, the first part and the second part may be connected one to each other at the lateral constriction, alternatively are connected through an intermediate portion. In the first alternative, the entire through hole is formed only by the first part (for instance a tapering first part) and the second part (for instance a tapering second part) so that the interface between the first part and the second part forms the lateral constriction. In the second alternative, the aforementioned first and second parts may not be connected directly with each other, but by a third part (for instance with inclined, curved or vertical sidewalls) in between. For instance, the properties of said third part may be defined or influenced by a third laser shot. By taking this measure, the desired shape of the through hole may be precisely adjusted.

In an embodiment, a first tapering angle of said first part and/or a second tapering angle of said second part is or are in a range from 0.2° to 30°, for example in a range from 1° to 10°. The thickness of the stack may be in a range from 100 µm to 1000 µm, for instance may be 300 µm. For example, the internal opening defined by the coating may be an hourglass shaped opening with inclination values smaller than the inclination values of the hourglass shaped through hole. For instance, the internal opening defined by the coating may also have a further lateral constriction at a position corresponding to the lateral constriction defined by the sidewalls delimiting the through hole in the stack. However, the internal opening defined by the coating may also be an hourglass shaped opening with inclination values larger than the inclination values of the hourglass shaped through hole.

In an embodiment, a first central axis of said first part and a second central axis of said second part are laterally displaced with respect to each other by a displacement value of less than 50 µm, for example less than 20 µm. In the context of the present application, the term "first central axis" may particularly denote a symmetry axis of a frustoconical or conical first part of the through hole extending from one main surface of the stack up to the lateral constriction. Correspondingly, the term "second central axis" may particularly denote a symmetry axis of a frustoconical or conical second part of the through hole extending from the other main surface of the stack up to the lateral constriction. A mutual spatial displacement between said central axes along a horizontal direction, i.e. perpendicular to said central axes, may be made sufficiently small by ensuring an only small spatial mismatch in between. For instance, this may be achieved by using alignment marks for properly positioning the laser sources on both opposing main surfaces of the stack. As a result, highly homogeneous properties of the through hole and of the coating may be achieved.

In an embodiment, a difference between a maximum thickness and a minimum thickness of the electrically insulating coating covering at least part of the sidewalls of the stack is in a range from 5% to 90%, for instance in a range from 50% to 90%, of the maximum thickness. For example, a "thickness" of the coating on a surface portion of the sidewall may be a coating thickness perpendicular to said surface portion (for instance perpendicular to a tangent on said surface portion). A "maximum thickness" on a sidewall may be the largest thickness on said sidewall between the two opposing main surfaces of the stack. A "minimum thickness" on a sidewall may be the smallest thickness on said sidewall between the two opposing main surfaces of the stack. More precisely, an absolute value of a ratio between, on the one hand, a difference between a maximum thickness of the coating on the sidewalls and a minimum thickness of the coating on the sidewalls and, on the other hand, the maximum thickness may be in at least one of the mentioned ranges. Hence, homogeneity of the sidewall coverage of the coating may be enhanced, since maximum thickness variations on different sidewalls portions may be limited to the mentioned values.

In an embodiment, a difference between a first amount (such as volume or mass) of the coating on one of two sides of the stack with respect to a horizontal symmetry plane (which may or may not extend through the lateral constriction) and a second amount (such as volume or mass) of the coating on the other one of the two sides of the stack with respect to the horizontal symmetry plane is in a range from 5% to 50% of said first amount or is not more than 10% of said first amount. The horizontal symmetry plane may virtually separate the stack into two halves of the same vertical thickness. According to the described design rule, an absolute value of a ratio between, on the one hand, a difference between the first amount of the coating on the stack above the horizontal symmetry plane and a second amount of the coating on the stack below the horizontal symmetry plane and, on the other hand, the first amount may be in at least one of the mentioned ranges. When depositing the electrically insulating coating on the dedicated stack surface, the sidewalls with the lateral constriction at or close to a central position of the stack may lead to a highly homogeneous coverage in terms of coating thickness along the through hole. This may have a stabilizing impact on the component carrier as a whole.

In an embodiment, a difference between a third amount (such as volume or mass) of the coating on one of two sides of the stack with respect to a vertical symmetry plane (which may or may not extend through the lateral constriction) of the stack and a fourth amount (such as volume or mass) of the coating on the other one of the two sides of the stack with respect to the vertical symmetry plane is in a range from 5% to 50% of said third amount or is not more than 10% of said third amount. Moreover, the vertical symmetry plane may or may not be overlapped with any one of the first central axis and the second central axis. The vertical symmetry plane may virtually separate the stack into two halves of the same horizontal length and width. According to the described design rule, an absolute value of a ratio between, on the one hand, a difference between the third amount of the coating on the stack on the left-hand side of the vertical symmetry plane and a fourth amount of the coating on the stack on the right-hand side of the vertical symmetry plane and, on the other hand, the third amount may be in at least one of the mentioned ranges. When depositing the electrically insulating coating on the dedicated stack surface, the sidewalls with the lateral constriction at or close to a central position of the stack may lead to a highly homogeneous coverage in terms of coating thickness on both sides of the through hole. This may have a stabilizing impact on the component carrier as a whole.

In a preferred embodiment, a distribution and/or an amount of the coating on two sides of the stack with respect to a horizontal symmetry plane (which may or may not extend through the lateral constriction) and/or with respect to a vertical symmetry plane (which may or may not extend through the lateral constriction) is symmetrical. Moreover, the vertical symmetry plane may or may not be overlapped with any one of the first central axis and the second central axis. This can be achieved in particular when the lateral constriction is arranged in the vertical center of the stack, i.e. very close to the middle between the two opposing main surfaces (for instance less than ±5% away from the exact middle), and when a spatial shift between the partial holes tapering from both opposing main surfaces of the stack into the stack to meet at the lateral constriction is close to zero (for instance less than ±10 µm), and/or when the first central axis and the second central axis are close to be overlapped.

In an embodiment, the component carrier comprises a solder resist structure on one or both opposing main surfaces of the stack apart from the coating (wherein "apart from the coating" may denote the fact that the solder resist and the coating do not overlap or contact in the described embodiment). In the context of the present application, the term "solder resist structure" may particularly denote a physical structure comprising solder resist material. In particular, such a structure may be a flat layer structure covering only part of the main surfaces the stack. Solder resist material of such a solder resist structure may protect the stack or part thereof against oxidation or corrosion, in particular may protect surface portions containing a metal such as copper. Furthermore, a solder resist may optionally define one or more surface portions of a stack of a component carrier on which no solder material shall and will attach. To put it shortly, the material of a solder resist may be selected so that solder material will not attach or remain on surface regions of a stack of a component carrier which are covered by the solder resist. A solder resist, which may also be denoted as solder mask, may be a thin lacquer-like layer, for instance of polymer, that may be applied to electrically conductive surface metal (in particular copper traces of a component carrier, such as a printed circuit board (PCB)) for protection against oxidation and to prevent solder bridges from forming between closely spaced solder pads. In this context, a solder bridge may be an unintended electrical connection between two electrically conductive structures by a spot of solder. A solder resist may prevent solder bridges. Once applied as a continuous layer on a stack, one or more openings can be created in the solder resist where material shall be electrically connected with electrically conductive layer structures of the stack, for instance for connecting them electrically with one or more surface mounted components to be soldered on the stack. Such openings may be formed by patterning the continuous layer of solder resist on the stack, for example using photolithography. For example, a solder resist may be formed based on epoxy liquid which may be silk-screened through a pattern or a mask onto the stack. It is also possible to form a solder resist on the basis of a liquid photoimageable solder mask ink which can be applied for example by spraying or silkscreening and can then be patterned. Furthermore, a solder resist may be created as a dry-film photoimageable solder mask which can be laminated and subsequently patterned on the stack.

In an embodiment, a thickness of the solder resist structure is larger than a thickness of the coating on the same main surface where the solder resist structure is provided. Advantageously, already a small thickness of the coating in the through hole may be sufficient for reliably protecting the exposed stack surface there.

In an embodiment, a material of the coating is an ink or a solder resist. When the coating is an ink, it may for instance provide the function of a colorant. Additionally or alternatively, it is also possible that the coating may be a solder resist (for instance with properties as defined above) or a further solder resist structure made of another material than the solder resist structure.

Thus, the coating and the solder resist structure may be different kinds of solder resist. In the context of the present application, the term "different kinds of solder resist" may particularly denote solder resists having different material compositions. For example, different kinds of solder resist may be a combination of at least two of at least one epoxy liquid-based solder resist, at least one liquid photoimageable solder mask ink, and/or at least one dry-film photoimageable solder mask. Different material compositions of different kinds of solder resist may lead to different properties of each respective solder resist, for instance in terms of electric isolation, anti-adhesion properties with respect to solder, color (for example green, blue, black), corrosion protection strength, coefficient of thermal expansion (CTE), mechanical strength, etc. Hence, two different kinds of solder resist may be provided on part of or on the entire surface of the stack.

In an embodiment, a horizontal extension of the coating covering one main surface of the stack is lower than a horizontal extension of the solder resist structure on said main surface. In particular, it may be possible to define a recess between said coating and said solder resist structure, more particularly having an electrically conductive layer structure exposed in said recess. For example, the solder resist structure may provide the functionality of protecting the main surfaces of the stack, whereas the coating may predominantly lead to an electrically insulating protection of the interior stack sidewalls. The extension of the coating up to a portion of the main surfaces of the stack being directly connected to the through hole may lead to an improved adhesion of the coating on the stack surface while also contributing to a surface protection of that connected portions of the main surfaces. A larger thickness of the solder resist compared with the coating may lead to a reliable dielectric protection of the main surfaces against corrosion, etc., while the smaller thickness of the coating may keep the functional through hole area or volume sufficiently large.

In an embodiment, the component carrier comprises a component, or a plurality of components. The one or more components may be surface mounted on the stack or embedded in the stack. In the context of the present application, the term "component" may particularly denote any bulky rather than layer-type block. The component may be an electronic component, such as an active (for example a semiconductor chip or semiconductor package) or passive (for instance a capacitor or an inductor) electronic component embedded or to be embedded within an interior of the component carrier. However, the component may also be a non-electronic component without electronic functionality. For example, the component may be a component with thermal functionality, such as a heat removal and/or heat spreading functionality. For example, the component may be a metal (for instance copper) block and/or ceramic block.

Preferably, said at least one component may be an optical component, i.e. a component with optical functionality. For example, the component carrier with component may be a camera module. For instance, the optical component may comprise an optical sensor. Such an optical sensor may be configured for capturing image data, video data or sensor data. Additionally or alternatively, the optical component may provide an optical emitter function. Such an optical emitter may be configured for emitting image data or video data. During operation of the component carrier with one or more optical components, optical electromagnetic radiation (such as visible light, infrared light and/or ultraviolet light) may propagate through the through hole.

Without wishing to be bound to a specific theory, it is presently believed that the coating and solder resist on the surface of the component carrier may prevent so-called momentary blazing phenomena resulting from light reflected by an exposed trace.

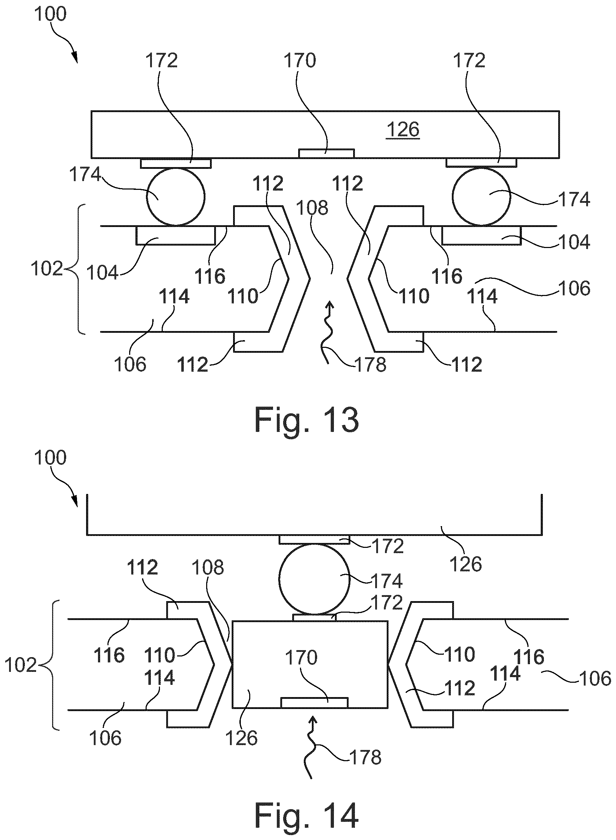

In an embodiment, the component carrier comprises a component, for example an optical component, being accommodated at least partially inside the through hole. Hence, at least part of the through hole may function for accommodating at least part of at least one optical component. Such an embodiment is shown, for example, in Figure 14.

In an embodiment, the component carrier comprises a component, for example an optical component, being surface-mounted on one main surface of the stack so as to cover the through hole. In particular, said at least one optically component may face the through hole. Such an embodiment is shown, for example, in Figure 13. For instance, at least one optically sensitive detection element and/or at least one optical emitting element of the at least one optical component may be aligned with the through hole in the stack, so that the at least one optical component mounted on the stack may functionally cooperate with electromagnetic radiation propagating through the stack and/or may emit electromagnetic radiation into the through hole. For example, said functional cooperation may comprise an alignment of the optical component with the through hole so that the optical component is capable of detecting light propagating through the through hole. Additionally or alternatively, said functional cooperation may comprise an alignment of the optical component with the through hole so that the optical component is capable of emitting light for propagating through the through hole.

In an embodiment, a thickness (for instance an average thickness, a maximum thickness or a minimum thickness) of the coating on one side of the lateral constriction differs from a thickness (for instance an average thickness, a maximum thickness or a minimum thickness) of the coating on another side of the lateral constriction by less than 20%, for example by less than 10%. According to the described design rule, an absolute value of a ratio between, on the one hand, a difference between said thickness of the coating on said one side of the lateral constriction and said thickness of the coating on said other side of the lateral constriction and, on the other hand, said thickness of the coating on said one side of the lateral constriction may be in at least one of the mentioned ranges. This high degree of homogeneity of the thickness of the coating on the surface of the stack may be achieved due to the high symmetry of an hourglass-shaped through hole with lateral constriction in a center.

In an embodiment, said coating covering part of said opposing main surfaces and at least part of said sidewalls of the stack forms an integral continuous structure. Thus, an uninterrupted coating structure or layer may be provided for protecting the covered stack surface by said coating, thereby preventing unprotected weak parts of the stack surface due to discontinuities. Furthermore, this may promote proper adhesion between coating and stack.

In an embodiment, a transition between at least one of the opposing main surfaces of the stack and the sidewalls is rounded. The avoidance of sharp corners may further promote the mechanical integrity of the coating on the stack surface. For the same reason, also the lateral constriction may be rounded, rather than being strictly angled.

In an embodiment, apart from the lateral constriction, the sidewalls are straight, curved and/or stepped. For example, both sidewalls may be inwardly tapering from the respective main surface of the stack up to the lateral constriction inside of the stack, with surfaces being straight and/or curved (for instance concavely curved). Alternatively, a stepped configuration may also lead to a design with interior lateral constriction.

In an embodiment, an exposed surface of the coating defines a further lateral constriction in between opposing main surfaces of the stack. Hence, not only the sidewalls of the stack delimiting the through hole may have a lateral constriction, but also the coating applied onto said surface. This may be a result of the homogeneous deposition characteristics of the coating thanks to the described through hole design.

In an embodiment, the method comprises forming the through hole in the stack by laser processing. In an embodiment, the through hole may be a laser through hole. The through hole may be formed in particular and preferably by laser processing. Formation of a through hole by laser processing from both main surfaces of an electrically insulating layer structure may be preferred for obtaining the described shape with lateral constriction. Advantageously, when forming the through hole by laser processing, substantially no glass fibers from prepreg material of the stack will extend into the through hole due to the impact of the laser beam. This may improve accuracy of the obtained geometry and may suppress artefacts. However, formation of a through hole may be carried out as well by other methods than laser processing, for instance by a plasma treatment, by wet etching, etc.

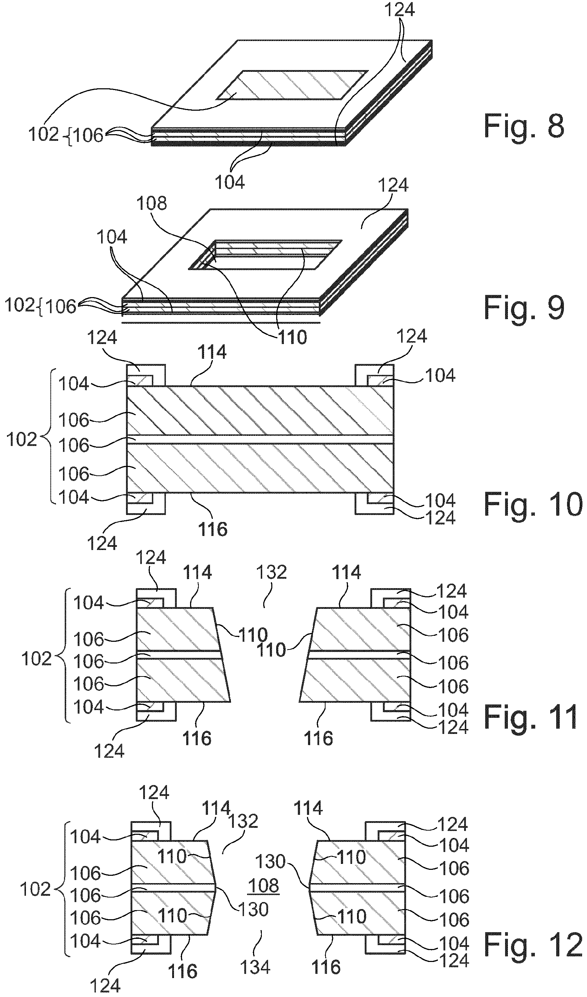

In an embodiment, said laser processing comprises forming a first part of the through hole by laser drilling from one of said main surfaces of the stack, and forming a second part of the through hole by laser drilling from the other one of said main surfaces of the stack. The first laser drilling process may form a blind hole or a continuously tapering through hole extending through the stack (see for instance Figure 11). The second laser drilling process following the first laser drilling process may remove additional stack material for shaping the through hole so as to form an hourglass-shaped through hole extending through the stack (see for instance Figure 12).

In an embodiment, the method comprises applying the coating on the sidewalls and on parts of the main surfaces using a roller. For instance, such a roller may be a cylindrical body rotating about its central symmetry axis during operation, for instance during application of the coating. Such a roller may be moved, while rotating, longitudinally along a corresponding main surface of the stack. It has been surprisingly found that by forming the coating using a roller (rather than a scarper), enhanced balance of sidewall thickness may be achieved. This may keep the through hole center at a consistent position before and after coating.

In an embodiment, the method comprises applying the coating on the sidewalls and on parts of the main surfaces using a pair of rollers (which may both be embodied as described above for the roller) rolling along the opposing main surfaces of the stack, preferably rolling simultaneously along the opposing main surfaces of the stack. By taking this measure, excellent accuracy of the coating and a highly precise characteristic of the coated through hole may be achieved.

In an embodiment, a stack of the component carrier comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through hole connections. The filled hole either connects the whole stack, (through hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as gra-phene or poly(3,4-ethylenedioxythiophene) (PEDOT), respectively.

At least one component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier obtained from the component carrier structure is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

The aspects defined above and further aspects of the invention are apparent from the examples of embodiment to be described hereinafter and are explained with reference to these examples of embodiment.

### Brief Description of the Drawings

Figure 1 illustrates a cross-sectional view of a component carrier according to an exemplary embodiment of the invention.
Figure 2 illustrates images of part of component carriers according to an exemplary embodiment of the invention.
Figure 3 to Figure 6 illustrate different views of structures obtained during carrying out a method of manufacturing a component carrier, shown in Figure 6, according to an exemplary embodiment of the invention.
Figure 7 to Figure 12 illustrate different views of structures obtained during carrying out a method of manufacturing a component carrier, shown in Figure 7, according to an exemplary embodiment of the invention.
Figure 13 illustrates a cross-sectional view of a component carrier according to an exemplary embodiment of the invention.
Figure 14 illustrates a cross-sectional view of a component carrier according to another exemplary embodiment of the invention.

The illustrations in the drawings are schematic. In different drawings, similar or identical elements are provided with the same reference signs.

### Detailed Description of Exemplary Embodiments

Before, referring to the drawings, exemplary embodiments will be described in further detail, some basic considerations will be summarized based on which exemplary embodiments of the invention have been developed.

In conventional approaches of forming an ink-type coating on a sidewall of a stack delimiting a through hole of a component carrier, the ink thickness on a cavity sidewall may be highly unbalanced. As a result, a cavity center position during the coating process may become unstable, i.e. it cannot be kept consistent before and after coating. A distance of a cavity center to a copper pad, as reference, may be unstable as well. Thus, conventional approaches cannot create a balanced sidewall thickness, which may cause a shift of a cavity center after coating. Conventionally, it may not be possible to control a distance of a cavity center to a pad with a sufficiently small tolerance. Sidewall coating on through holes of component carrier stacks may be quite uncontrolled and unsatisfactory in conventional approaches.

According to an exemplary embodiment of the invention, a (for instance printed circuit board-type) component carrier with (for example laminated) layer stack is provided with an at least essentially vertical through hole extending between a front side and a back side of the stack. Despite of the essentially vertical extension of the through hole through the stack, its lateral sidewalls providing an interface to the circumferential stack material may have a lateral constriction rather than extending vertically. For instance, the through hole may have an hourglass shape composed of two opposingly tapering frustoconical partial holes. Such a shape may be created for example by two-sided laser drilling with correspondingly adjusted operation parameters. In addition, an electrically insulating coating may be deposited on a surface portion of the stack including parts of the opposing main surfaces and at least part of the interior sidewalls defining the through hole with lateral constriction. For example, said coating or lining may provide a solder resist functionality for providing chemical and/or mechanical protection. Advantageously, exemplary embodiments ensure a very homogeneous sidewall coverage of said coating in and around the through hole. A tapering hourglass-type shape of the through hole may result in a precisely controllable homogeneous amount and positioning of said coating. By locally increasing a through hole size by a two-sided formation, the available volume for providing a functionality (for instance positioning a component) may be increased on either side of the stack. By appropriately adjusting the laser processing parameters (for instance laser energy and/or wavelength, irradiation duration, pulsed or continuous irradiation) for forming the lateral constriction inside the through hole, it may be possible to keep the lateral shift sufficiently small. More precisely, by individually or commonly adjusting the above-mentioned and/or other laser parameters for the two (or more) laser shots from both opposing main surfaces of the stack (preferably subsequently or simultaneously), one or more characteristics of the lateral constriction may be adjusted accurately. This may result in very symmetric properties of the component carrier as a whole and may reduce artefacts like warpage and delamination. A through hole with lateral constriction may provide advantageous properties for a component (in particular an optical component) to be mounted on a main surface of the stack with functional access to the through hole and/or to be mounted at least partially in the through hole. Advantageously, the described architecture may make it possible to obtain a more or even highly balanced sidewall thickness of a stack coating in a through hole avoiding an excessive center shift due to coating. In a nutshell, formation of a through hole with lateral constriction in a stack may provide a component carrier with stability in terms of coating control. For instance, a minimum through hole diameter may be in a range from 50 µm to 800 µm, in particular in a range from 100 µm to 400 µm.

Thus, an exemplary embodiment provides a component carrier with a through hole having a symmetric taper shape in the through hole or cavity. Compared with a continuously tapering through hole in a stack, the tapering characteristics of the hourglass-shaped through hole according to an exemplary embodiment may be less pronounced, and the shape may be more symmetric. Consequently, the coating thickness may be very similar or identical on both sides of the lateral constriction.

Excellent results concerning the described through hole shape may be obtained when laser cutting the through hole is accomplished using a picosecond laser cutting process. A laser cutting process may allow to make the taper shape in the cavity or through hole symmetric. This may have a positive impact on accuracy of the through hole or cavity size control and coating thickness homogeneity. A laser cutting process executed from both sides of the stack may make the taper symmetric. This may lead to a better cavity size performance and (for instance solder mask-type) coating thickness on the cavity or through hole edge. Improved capability of cavity size control and coating sidewall thickness performance may be helpful for dimension sorting rate improvement.

An exemplary application of exemplary embodiments is a component carrier-based camera module. As camera modules are getting bigger, it may be challenging to fit a bigger camera sensor with tight specification requirement to a cavity or through hole in a component carrier stack. A symmetric taper may positively effect the sidewall solder resist thickness and camera module dimension. By reducing the cavity size variation according to exemplary embodiments, it may be possible to obtain a capability increase and power promotion. Thus, the mentioned and/or other advantages may be particularly pronounced when the component carrier with a component mounted in alignment with the coated through hole is implemented as a camera module.

Preferably, the through hole may be formed by laser cutting technology. It may be possible to cut a frame with large diameter directly and then take out the separated dummy part in the middle area. This allows to avoid cutting a big hole, but an annular (for example a rectangular) cutting area may be sufficient. For instance, the size of the obtained structure may be no larger than 7 mm * 10 mm.

In another embodiment (for instance if a large diameter has to be drilled), a combination of mechanical drilling and laser drilling may be applicable. A mechanical drill may be made first, and a fine structuring laser drill may be carried out thereafter. This may also reduce the drilling time since removal of a lot of material with laser can be avoided.

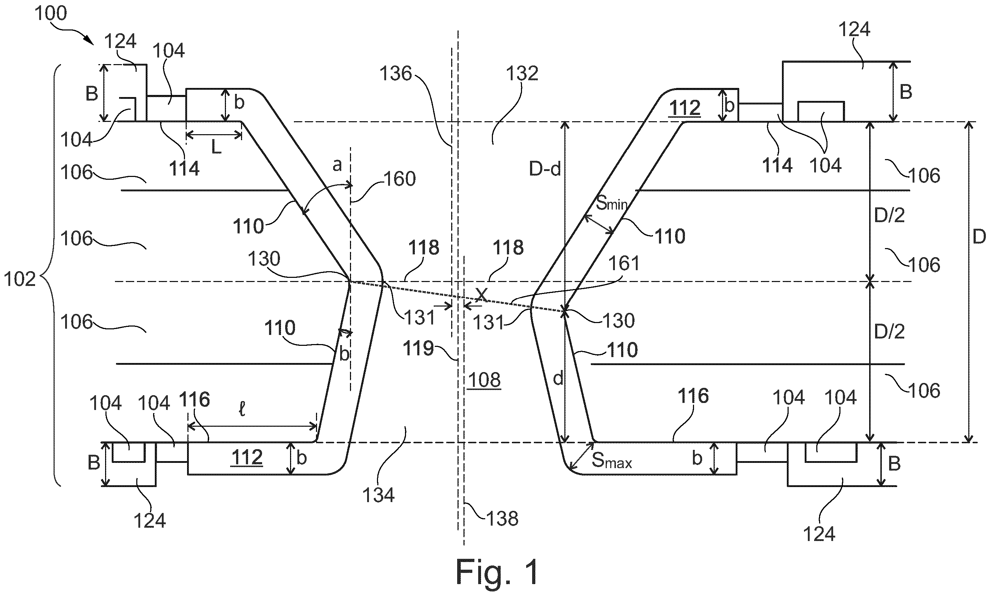

**Figure 1** illustrates a cross-sectional view of a component carrier 100 according to an exemplary embodiment of the invention. In the shown embodiment, component carrier 100 is embodied as a printed circuit board (PCB). However, component carrier 100 may also be an integrated circuit (IC) substrate, etc.

Component carrier 100 according to Figure 1 comprises a laminated layer stack 102 comprising a plurality of electrically conductive layer structures 104 and of electrically insulating layer structures 106. Stack 102 of Figure 1 may comprise layers and vias (not shown) in a build-up construction. It is in particular possible that a stack 102 is provided being embodied with a core in a layers stack.

The electrically conductive layer structures 104 may comprise patterned copper layers which may form horizontal pads and/or horizontal wiring structures. Additionally, the electrically conductive layer structures 104 may comprise vertical through connections such as copper pillars and/or copper filled laser vias. Additionally or alternatively, mechanical plated through holes (PTH) may also be used as vertical through connections. Moreover, the stack 102 of the component carrier 100 may comprise one or more electrically insulating layer structures 106 (such as one or more prepreg sheets, resin sheets or cores made of FR4). Ajinomoto Build-Up Film ^{®} (ABF) materials are also possible for at least part of the electrically insulating layer structures 106, in particular when the component carrier 100 is embodied as an IC substrate. Also surface finish (like ENIG or ENEPIG, etc.) may be optionally applied on the top side and/or on the bottom side of the stack 102 (not shown).

As shown as well in Figure 1, a through hole 108 is formed in stack 102 and extends vertically through the entire stack 102. When forming through holes 108 by laser drilling or laser cutting from both opposing main surfaces 114, 116 of stack 102 with appropriate laser parameters (such as laser wavelength, laser energy, irradiation time, pulsed or continuous irradiation, etc.) and a respective laser source (not shown) arranged on both the top side and the bottom side of the stack 102 according to Figure 1, the through hole 108 can be defined by and between interior sidewalls 110 of the stack 102 leading to a lateral constriction 130 or bottleneck in a center of the through hole 108. In the illustrated embodiment, lateral constriction 130 may be defined by a rounded section of the sidewalls 110, but may also be sharp-angled or stepped. Two slanted and opposingly tapering (rather than vertical) portions of sidewall 110 on an upper side and on a lower side of the lateral constriction 130 include, with a vertical direction 160 being perpendicular to opposing horizontal main surfaces 114, 116 of stack 102, an angle α≠0 in an upper portion of through hole 108 and an angle β≠0 in a lower portion of through hole 108. For example, each of the tapering angles α, β between the sidewalls 110 and vertical direction 160 perpendicular to said main surfaces 114, 116 may be in a range from 2° to 10°. Alternatively, each of the tapering angles α, β between the sidewalls 110 and vertical direction 160 perpendicular to said main surfaces 114, 116 may be in a range from 10° to 45°. In a preferred example, the tapering angle α may be different from the tapering angle β. Alternatively, the tapering angles α, β may be the same. According to Figure 1, the through hole 108 has an hourglass shape formed by two frustoconical portions with mutually inverse tapering characteristics. Each of the two frustoconical portions tapers from a respective main surface 114, 116 of stack 102 towards an interior of the through hole 108 up to its narrowest section at lateral constriction 130.

Still referring to Figure 1, an electrically insulating coating 112 may be formed to cover part of both opposing main surfaces 114, 116 of the stack 102 and the whole sidewalls 110 of the stack 102. More specifically, the electrically insulating coating 112 lines the entire sidewalls 110 defining through hole 108 and also lines a respective annular section of each of the main surfaces 114, 116 which directly surrounds the through hole 108 on both ends. A horizontal extension length L of the coating 112 covering one main surface 114 of the stack 102 may differ from another horizontal extension length I of the coating 112 covering the opposing other main surface 116 of the stack 102.

For instance, the electrically insulating coating 112 may be an ink or a solder resist. An ink may comprise a colorant for providing the electrically insulating coating 112 with a defined color. A solder resist may protect the covered surface of stack 102, for instance against corrosion or oxidation, for ensuring dielectric isolation, for providing a mechanical protection, etc. For instance, the solder resist may be made of a material of the Taiyo DF series (ME1-Z, SR1, etc.). For example, the coating ink may be made of Taiyo D60ME/D10ME material.

As shown as well in Figure 1, a solder resist structure 124 may be applied on the opposing main surfaces 114, 116 of the stack 102 in surface regions apart from the coating 112. Also the coating 112 may be embodied as a further solder resist structure and may be made of another material than (or may be made of the same material as) the solder resist structure 124. When the materials of solder resist structure 124 and solder resist-type coating 112 are different from each other, this may allow to adjust the local solder resist properties of component carrier 100 separately and individually. In the shown embodiment, a thickness B of the solder resist structure 124 on the respective one of the main surfaces 114, 116 is larger than a thickness b of the coating 112 on the respectively same main surface 114, 116. Alternatively, B may be smaller than b or B=b. Furthermore, a horizontal extension of the coating 112 covering the respective one of the main surfaces 114, 116 of the stack 102 is lower (or alternatively higher) than a horizontal extension of the solder resist structure 124 on said respective main surface 114, 116.

Preferably, a lateral recess may be formed between said coating 112 and said solder resist structure 124 on the respective one of the main surfaces 114, 116, so that coating 112 and solder resist structure 124 do not overlap or contact in a lateral direction. This may allow to expose an electrically conductive layer structure 104, such as a pad (for instance a copper pad), exposed in said recess between solder resist-type coating 112 and solder resist structure 124 for connection purposes. Another electrically conductive layer structure 104 on the respective one of the main surfaces 114, 116, such as a further pad or wiring structure (for instance a further copper pad or wiring structure), may be covered by the solder resist structure 124 for protection purposes. Although not shown, it may also be possible that coating 112 and solder resist structure 124 overlap or contact with each other.

Now referring in detail to Figure 1, a partial vertical distance d from the main surface 116 to the lateral constriction 130 may in a range from 45% to 55% of an overall vertical distance D between the opposing main surfaces 114, 116. In other words, a partial vertical distance D-d from the main surface 114 to the lateral constriction 130 may be very similar to the partial vertical distance d. Thus, the lateral constriction 130 may be at or close to the middle of the stack 102 along its thickness direction. For example, the overall vertical distance D between the opposing main surfaces 114, 116 may be in a range from 100 µm to 1000 µm, for example may be 300 µm.

As shown as well in Figure 1, a first part 132 of the through hole 108 tapers from main surface 114 of the stack 102 up to the lateral constriction 130. Correspondingly, a second part 134 of the through hole 108 tapers from the other main surface 116 of the stack 102 up to the lateral constriction 130. The first part 132 and the second part 134 meet each other at or around lateral constriction 130 to form an hourglass-like shape of the through hole 108. Hence, in the shown embodiment, the first part 132 and the second part 134 are connected one to each other directly at the lateral constriction 130. Alternatively, the first part 132 and the second part 134 may be connected to each other indirectly through an intermediate portion (such as a central vertical section or the like, not shown). The first part 132 may have a frustoconical shape with a first central axis 136, and the second part 134 may have a further frustoconical shape with a second central axis 138. As shown, the first central axis 136 of said first part 132 and the second central axis 138 of said second part 134 may be laterally displaced with respect to each other by a displacement value x which is preferably less than 20 µm. Such a lateral displacement may result from a small spatial misalignment between a first laser source forming the first part 132 by laser irradiation of the first main surface 114 from the front side and a second laser source forming the second part 134 by laser irradiation of the second main surface 116 from the back side. By the use of alignment marks (not shown) on the stack 102, said misalignment may be efficiently reduced so as to meet the above-mentioned demanding specification. Such a small spatial misalignment between two frustoconical partial holes may lead to a homogeneous coverage of the sidewall 110 by coating 112.

Figure 1 shows portions of coating 112 with different thicknesses, in particular a portion with maximum thickness Smax and another portion with minimum thickness Smin. Advantageously, a difference between the maximum thickness Smax and the minimum thickness Smin of the electrically insulating coating 112 covering the sidewalls 110 of the stack 102 may be not more than 20% of the maximum thickness Smax. For example, the maximum thickness Smax may be a controlled value larger than zero. For instance, the minimum thickness Smin may be in a range from 30 µm to 70 µm. Hence, the overall variation of the thickness of the coating 112 over the extension of the sidewalls 110 may be relatively small.

Also a high degree of symmetry of distribution of coating material over the exposed surface of the stack 102 including through hole 108 may be achieved. More specifically, a difference between a first amount of the coating 112 on the upper side of the stack 102 with respect to a horizontal symmetry plane 118 (which may or may not extend through the lateral constriction 130) of the stack 102 and a second amount of the coating 112 on the lower side of the stack 102 with respect to the horizontal symmetry plane 118 may be preferably not more than 20% of said first amount. Additionally or alternatively, a difference between a third amount of the coating 112 on the left-hand side of the stack 102 with respect to a vertical symmetry plane 119 (which may or may not extend through the lateral constriction 130) of the stack 102 and a fourth amount of the coating 112 on the right-hand side of the stack 102 with respect to the vertical symmetry plane 119 may be not more than 20% of said third amount. This high degree of homogeneity of coating distribution may be achieved with the described through hole design and manufacturing process. It may be most preferred that a distribution and/or an amount of the coating 112 on two sides of the stack 102 with respect to horizontal symmetry plane 118 and/or with respect to vertical symmetry plane 119 is symmetrical. A symmetrical configuration in this sense may be achieved when one or both of the aforementioned percentages is below 5%.

As shown, said coating 112 covering part of said opposing main surfaces 114, 116 and the entire sidewalls 110 of the stack 102 forms an integral continuous structure. Thus, coating 112 may extend without interruptions over two opposing annular sections on the main surfaces 114, 116 and over the whole sidewall surface in between to thereby form a continuous sleeve surface with the two connected annular sections. Hence, a continuous surface region of the stack 102 may be protected by the coating 112.

As shown in Figure 1, a transition between each one of the opposing main surfaces 114, 116 of the stack 102 and the sidewalls 110 is rounded. Also the lateral constriction 130 may be rounded. This geometry may improve the surface adhesion of the coating 112 on the exposed surface of the stack 102. As an alternative to the respective rounded section, also a sharp-corner transition is possible in other embodiments (not shown). Also an exposed surface of the coating 112 in an interior of the through hole 108 defines a further lateral constriction 131 in between opposing main surfaces 114, 116 of the stack 102. Also the further lateral constriction 131 may be rounded or sharp-angled.

As illustrated as well in Figure 1, a connection line 161 between the lateral constrictions 130 (and/or a connection line (not shown) between the further lateral constrictions 131) may be inclined compared to the horizontal symmetry plane 118. Alternatively, the connection line 161 between the lateral constrictions 130 (and/or the connection line between the further lateral constrictions 131) may be parallel to the horizontal symmetry plane 118.

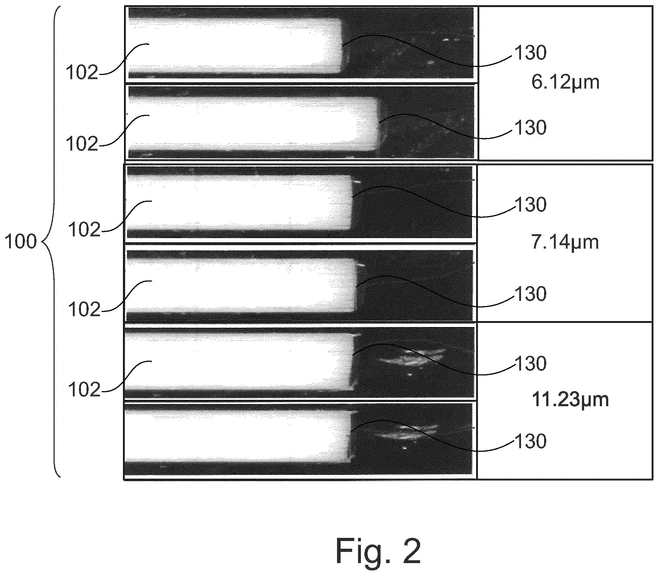

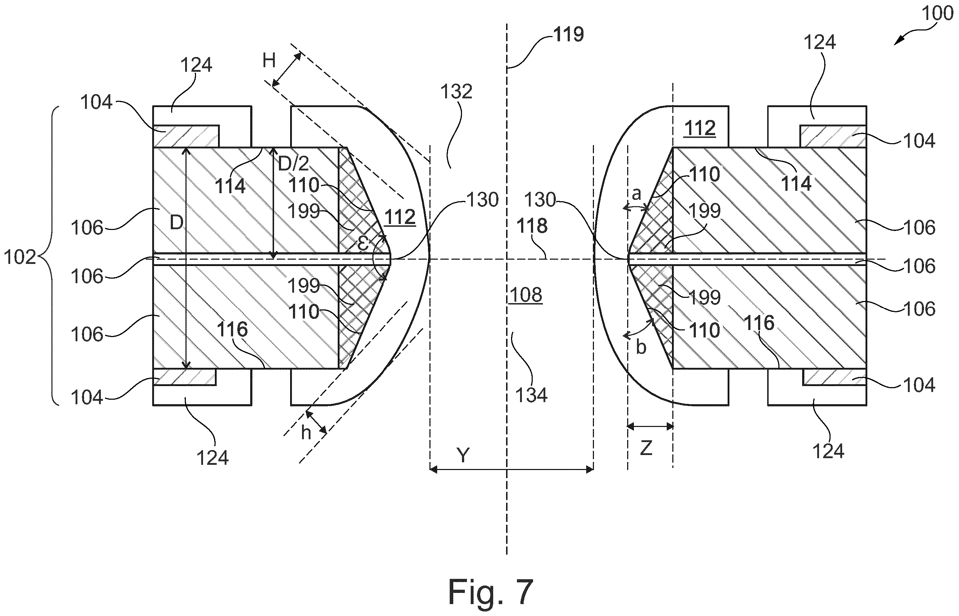

**Figure 2** illustrates images of part of component carriers 100 according to an exemplary embodiment of the invention. Many of the parameters and properties described referring to Figure 1 can be seen in Figure 2 as well. The numbers shown in Figure 2 refer to the width Z as illustrated in Figure 7, which may be indicative of the extent of the tapering.

In different embodiments, the insulating coating 112 may have variable thickness on the sidewalls 110 according to a direction parallel to main surface extension. Furthermore, at least parts of the insulating coating 112 may have concave and/or convex portions.

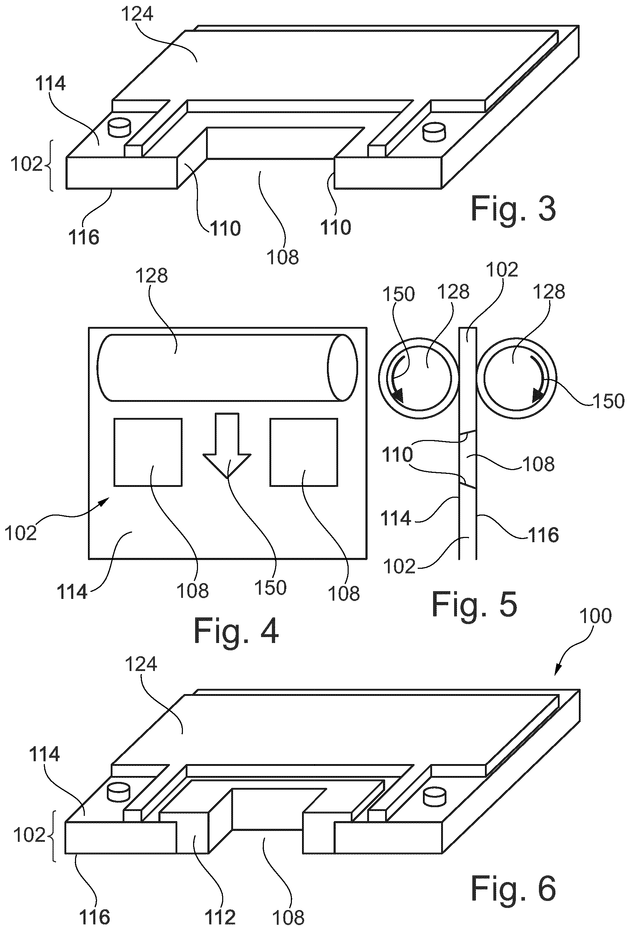

Figure 3 to Figure 6 illustrate different views of structures obtained during carrying out a method of manufacturing a component carrier 100, shown in Figure 6, according to an exemplary embodiment of the invention.

Referring to the three-dimensional view of **Figure 3****,** a laminated layer stack 102 is illustrated which may comprise electrically conductive layer structures 104 and electrically insulating layer structures 106 (not shown), which may be embodied as described referring to Figure 1. A through hole 108 has been formed in the stack 102 by laser drilling or laser cutting having a lateral constriction 130 (not shown) between opposing main surfaces 114, 116 of the stack 102. Furthermore, a solder resist structure 124 has been applied and patterned on a portion of main surface 114 of stack 102.

Referring to **Figure 4** (showing a plan view) and **Figure 5** (showing a side view), a process of covering a surface portion of the component carrier pre-form of Figure 3 will be explained. As shown also in Figure 6, the ink-type or solder resist-type coating 112 may be applied on the entire sidewalls 110 and on directly connected parts of the main surfaces 114, 116 using rollers 128 moving with a combined longitudinal and rotating motion during coating application in a way as is shown by arrows 150. During applying the material of the coating 112 on the sidewalls 110 and on the connected parts of the main surfaces 114, 116, a pair of rollers 128 may be used which roll along the opposing main surfaces 114, 116 of the stack 102. Preferably, the rollers 128 roll simultaneously along the opposing main surfaces 114, 116 of the stack 102. By taking this measure, the material of the coating 112 can be applied evenly to substantially the entire sidewalls 110 of the stack 102 delimiting through hole 108. The homogeneity of the obtained sidewall coverage by coating 112 may be significantly improved by using rollers 128 impacting simultaneously opposing main surfaces 114, 116 of stack 102 for lining sidewalls 110 delimiting through hole 108 with lateral constriction 130, compared with conventional approaches which apply coating for instance using a scarper.

However, alternative methods (compared with Figure 4 and Figure 5) of forming the coating 112 are possible, like spray coating, screen printing, etc.

Referring to **Figure 6****,** the result of the described homogeneous application of coating 112 onto the sidewalls 110 of stack 102 with lateral constriction 130 is shown. More precisely, the result of the described manufacturing method is an electrically insulating coating 112 on annular parts of both opposing main surfaces 114, 116 of the stack 102 and on the entire surface area of sidewalls 110 of stack 102 including the lateral constriction 130 of the stack 102.

Figure 7 to Figure 12 illustrate different views of structures obtained during carrying out a method of manufacturing a component carrier 100.

As shown in **Figure 8****,** a three-dimensional view of a stack 102 (which can be constructed as described above referring to Figure 1) is shown with a patterned solder resist structure 124 covering part of main surfaces of the stack 102.

As shown in **Figure 9****,** a through hole 108 may be formed in stack 102 by laser processing, said through hole 108 being delimited by sidewalls 110 having a lateral constriction 130.

**Figure 10** shows a cross-sectional view corresponding to Figure 8. **Figure 11** shows a further cross-sectional view after part of the laser processing. As shown in Figure 11, said laser processing comprises forming a first part 132 of the through hole 108 by laser drilling from one main surface 114 of the stack 102.

**Figure 12** shows a further cross-sectional view after completing the laser processing. As shown in Figure 12, said laser processing comprises forming a second part 134 of the through hole 108 by laser drilling from the other main surface 116 of the stack 102. Thereby, the lateral constriction 130 is formed at the inner sidewalls 110 of the stack 102.

Back referring to **Figure 7****,** coating 112 may then be applied to the entire sidewalls 110 including the lateral constriction 130 and parts of main surfaces 114, 116 of the structure shown in Figure 12. As a result, a structure similar to Figure 1 can be obtained. As shown, said coating 112 covering part of both opposing main surfaces 114, 116 of the stack 102 and the sidewalls 110 of the stack 102 forms an integral continuous structure. This may improve the mechanical integrity of the component carrier 100. As shown as well, the taper shape on both lateral sides of the through hole 108 may be in accordance with an equilateral triangle 199.

The thickness of the coating 112 on the sidewalls 110 may be substantially homogeneously, i.e. H≈h. More generally, larger thickness H of the coating 112 on one side of the lateral constriction 130 may differ from smaller thickness h of the coating 112 on another side of the lateral constriction 130 by less than 20%, for example by less than 10%. For example, a thickness (such as h or H) of the coating 112 may be in a range from 5 µm to 30 µm, in particular in a range from 10 µm to 20 µm.

A minimum diameter, Y of the through hole 108 or cavity including coating 112 may be in a range from 2 mm to 20 mm, in particular in a range from 5 mm to, for example, 7 mm to 8 mm. A width, Z, of a lateral tapering section of the stack 102 may be significantly reduced compared with approaches having a tapering through hole formed by one laser shot only. A tapering angle, ε, of the lateral tapering section of the stack 102 at the lateral constriction 130 may be in a range from 162° to 178°, preferably in a range from 165° to 175°, for example 170°. More generally, the tapering angle, ε, may be in a range from 160° to 185°.

**Figure 13** illustrates a cross-sectional view of a component carrier 100 according to an exemplary embodiment of the invention.

According to Figure 13, component carrier 100 comprises a surface mounted optical component 126. For example, component 126 may comprise an optically sensitive camera element 170 configured for capturing optical data corresponding to light propagating through the through hole 108. Component 126 may comprise electrically conductive pads 172 which may be electrically coupled with pads corresponding to electrically conductive layer structures 104 exposed on a main surface 116 of stack 102. For instance, said electric coupling may be accomplished by solder structures 174. Optical component 126 being surface-mounted on main surface 116 of the stack 102 may face and may be aligned with the through hole 108 to enable an optical communication between optically sensitive camera element 170 through hole 108 and a side of stack 102 facing away from component 126. Electromagnetic radiation, such as light 178, may propagate through the through hole 108 towards the optically sensitive camera element 170 of component 126 for optical detection. Signals relating to the detected information may be transmitted from component 126 to stack 102 via the electrically conductive pads 172 which are electrically coupled with the pads corresponding to the electrically conductive layer structures 104 exposed on main surface 116 of stack 102.

However, other ways of establishing an electrical connection are possible as well rather than connecting the electrically conductive pads 172 with the pads corresponding to the electrically conductive layer structures 104 by solder, sinter or conductive glue. For example, it may be possible to connect the electrically conductive pads 172 with the pads corresponding to the electrically conductive layer structures 104 by wire bonding, for instance using bond wires or bond ribbons. Also clips may be used for this purpose. Wire or clip bonding may also allow to couple electrically conductive pads 172 with the pads corresponding to the electrically conductive layer structures 104 being arranged side by side, for instance at the same vertical level.

Furthermore, the component 126 may be in direct contact with the coating material, in particular at a portion of the sidewall 110 of the through hole 108.

**Figure 14** illustrates a cross-sectional view of a component carrier 100 according to another exemplary embodiment of the invention. This embodiment may include one or more optical components 126. One optical component 126 may be accommodated inside the through hole 108.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A component carrier (100), wherein the component carrier (100) comprises:
a stack (102) comprising at least one electrically conductive layer structure (104) and at least one electrically insulating layer structure (106);
a through hole (108) extending vertically through the stack (102) and being delimited by sidewalls (110) of the stack (102) having a lateral constriction (130) in between opposing main surfaces (114, 116) of the stack (102); and
an electrically insulating coating (112) covering part of said opposing main surfaces (114, 116) and at least part of said sidewalls (110) of the stack (102).

2. The component carrier (100) according to claim 1, wherein a vertical distance from one of the main surfaces (114, 116) to the lateral constriction (130) is in a range from 20% to 80%, in particular in a range from 45% to 55%, of another vertical distance between the opposing main surfaces (114, 116).

3. The component carrier (100) according to claim 1 or 2, wherein a first part (132) of the through hole (108) tapers from one of said main surfaces (114, 116) of the stack (102) up to the lateral constriction (130), and a second part (134) of the through hole (108) tapers from the other one of said main surfaces (114, 116) of the stack (102) up to the lateral constriction (130).

4. The component carrier (100) according to any of claims 1 to 3, wherein a difference between a maximum thickness (Smax) and a minimum thickness (Smin) of the electrically insulating coating (112) covering at least part of the sidewalls (110) of the stack (102) is in a range from 5% to 90%, for instance in a range from 50% to 90%, of the maximum thickness (Smax).

5. The component carrier (100) according to any of claims 1 to 4, wherein a difference between a first amount of the coating (112) on one of two sides of the stack (102) with respect to a horizontal symmetry plane (118) and a second amount of the coating (112) on the other one of the two sides of the stack (102) with respect to the horizontal symmetry plane (118) is in a range from 5% to 50% of said first amount or is not more than 10% of said first amount.

6. The component carrier (100) according to any of claims 1 to 5, wherein a difference between a third amount of the coating (112) on one of two sides of the stack (102) with respect to a vertical symmetry plane (119) of the stack (102) and a fourth amount of the coating (112) on the other one of the two sides of the stack (102) with respect to the vertical symmetry plane (119) is in a range from 5% to 50% of said third amount or is not more than 10% of said third amount.

7. The component carrier (100) according to any of claims 1 to 6, comprising a solder resist structure (124) on one or both opposing main surfaces (114, 116) of the stack (102) apart from the coating (112).

8. The component carrier (100) according to claim 7, wherein the coating (112) is a further solder resist structure made of another material than the solder resist structure (124).

9. The component carrier (100) according to any of claims 1 to 8, comprising a component (126), for example an optical component, being accommodated at least partially inside the through hole (108), and /or comprising a component (126), for example an optical component, being surface-mounted on one main surface of the stack (102) so as to cover the through hole (108).

10. The component carrier (100) according to any of claims 1 to 9, wherein a thickness of the coating (112) on one side of the lateral constriction (130) differs from a thickness of the coating (112) on another side of the lateral constriction (130) by less than 20%, for example by less than 10%.

11. The component carrier (100) according to any of claims 1 to 10, wherein a transition between at least one of the opposing main surfaces (114, 116) of the stack (102) and the sidewalls (110) is rounded.

12. The component carrier (100) according to any of claims 1 to 11, wherein, apart from the lateral constriction (130), the sidewalls (110) are straight, curved and/or stepped.

13. The component carrier (100) according to any of claims 1 to 12, wherein an exposed surface of the coating (112) defines a further lateral constriction (131) in between opposing main surfaces (114, 116) of the stack (102).

14. A method of manufacturing a component carrier (100), wherein the method comprises:
providing a stack (102) comprising at least one electrically conductive layer structure (104) and at least one electrically insulating layer structure (106);
forming a through hole (108) extending vertically through the stack (102) and being delimited by sidewalls (110) of the stack (102) having a lateral constriction (130) between opposing main surfaces (114, 116) of the stack (102); and
forming an electrically insulating coating (112) covering part of said opposing main surfaces (114, 116) and at least part of said sidewalls (110) of the stack (102).

15. The method according to claim 14, wherein the method comprises forming the through hole (108) in the stack (102) by laser processing.
